# DEMANDE DE BREVET EUROPEEN

(11) **EP 1 093 189 A1**
(43) Date de publication de la demande: **18.04.2001**
(21) Numéro de dépôt: 99810929.2
(22) Date de dépôt: 13.10.1999
(51) Int. Cl.: H01R 12/08, H05K 3/36

(54) **Système d'interconnexion électrique**

(71) Demandeur: MIDEV SA, 2854 Bassecourt (CH)
(72) Inventeur: Bron, Alphonse, 2854 Bassecourt (CH); Faivre, Sabine, 2907 Rocourt (CH)
(74) Mandataire: Gresset, Jean

(57) **Abrégé**

Système d'interconnexion électrique comportant:
- deux circuits imprimés (10, 28) ayant des portions superposées et comprenant chacun un substrat (12, 30) et un réseau de pistes conductrices (14, 32) qui sont formées sur le substrat et sont dotées de plages de connexion (16, 34) dans leurs portions superposées ,
- des moyens de positionnement desdites plages en regard les unes des autres, et
- des moyens d'assemblage (26, 54, 60) des deux circuits imprimés entre eux.
Lesdits moyens de positionnement comportent, d'une part, au moins deux fenêtres (22, 42, 44) identiques respectivement pratiquées dans chacune desdites portions et dont le pourtour est au moins partiellement défini par des bandes de guidage (20, 40) constituées de pistes conductrices appartenant audit réseau (14, 32) et, disposées de manière identique par rapport aux plages de connexion (16, 34) et, d'autre part, un organe de positionnement (24, 46) introduit dans les deux fenêtres (22, 42, 44) à l'intérieur desquelles il est ajusté.

## Description

La présente invention se rapporte aux systèmes d'interconnexion électrique du type comportant:
- deux circuits imprimés ayant des portions superposées et comprenant chacun un substrat et un réseau de pistes conductrices qui sont dotées de plages de connexion dans leurs portions superposées,
- des moyens de positionnement desdites plages en regard les unes des autres, et
- des moyens d'assemblage des deux circuits entre eux.

De tels systèmes sont bien connus de l'homme du métier. Ils permettent de relier entre eux des circuits électroniques qui doivent pouvoir être ensuite séparés les uns des autres.

Une solution couramment utilisée consiste à assembler les deux circuits imprimés à l'aide d'un connecteur, tel que celui vendu par la maison 3M (USA) sous la référence 5303R, formé d'une feuille de matériau thermo-soudable dans laquelle des particules conductrices sont noyées, avec une densité telle qu'elles assurent une conduction dans l'épaisseur de la feuille uniquement. Cette feuille est fixée par chauffage sur les portions superposées des circuits qui portent les pistes conductrices. Avant d'effectuer l'assemblage, les deux circuits sont positionnés l'un par rapport à l'autre en alignant simplement leurs bords, en utilisant une goupille engagée dans des découpes, ou encore, par des moyens optiques lorsque les substrats sont translucides.

Pour miniaturiser de tels systèmes en toute sécurité, il est nécessaire d'améliorer d'autant la précision que le pas entre les plages est réduit. Cela constitue une limitation à la miniaturisation. Or, avec les techniques de travail en bande actuellement utilisées pour la fabrication de circuits, un fontionnement sûr est possible seulement si le pas entre les plages de connexion est au moins égal à 0.3 mm.

Le but principal de la présente invention est de permettre une réduction sensible du volume occupé par la partie du dispositif assurant la liaison électrique entre deux circuits imprimés.

Pour atteindre ce but, le système de connexion selon l'invention, du type défini ci-dessus, est caractérisé en ce que les moyens de positionnement de leurs plages de connexion en regard les unes des autres comportent, d'une part, au moins deux fenêtres identiques respectivement pratiquées dans chacune desdites portions et dont le pourtour est au moins partiellement défini par des bandes de guidage constituées de pistes conductrices appartenant au réseau de pistes du circuit et disposées de manière identique par rapport aux plages de connexion et, d'autre part, un organe de positionnement introduit dans les deux fenêtres à l'intérieur desquelles il est ajusté.

De façon avantageuse, chacune desdites portions superposées comporte deux fenêtres pratiquées respectivement de chaque côté de son réseau de pistes conductrices.

Selon un mode de réalisation, l'organe de positionnement est formé d'un bouton comportant une portion médiane rétrécie et deux extrémités, ladite portion médiane étant ajustée dans lesdites fenêtres et les bords desdites extrémités prenant respectivement appui sur les deux circuits.

Selon un autre mode de réalisation, l'organe de positionnement est formé de deux éléments accouplés entre eux au travers desdites fenêtres et comportant une portion rétrécie et une base, les portions rétrécies étant ajustées dans les fenêtres et les bords desdites bases prenant respectivement appui sur les deux circuits. Dans ce cas, lesdits éléments sont, de préférence, identiques et comportent au moins une partie femelle et au moins une partie mâle . Ils sont accouplés tête-bêche de manière à ce que la partie mâle de l'un prenne place dans la partie femelle de l'autre.

Il est avantageux que les organes de positionnement disposés d'un même côté d'une desdites portions superposées soient reliés rigidement l'un à l'autre.

Il est également avantageux que l'organe de positionnement soit maintenu par accrochage à au moins l'un des deux circuits.

Les moyens d'assemblage peuvent soit comporter une couche de matériau thermo-soudable conducteur assurant non seulement le collage des deux substrats, mais également la liaison électrique des plages de connexion, soit comporter deux barrettes rigides disposées de part et d'autre des deux circuits au niveau de l'organe de positionnement et des moyens pour accoupler lesdites barrettes et serrer entre elles les circuits. Dans ce deuxième cas, un bourrelet élastique est avantageusement interposé entre chaque barrette et le circuit, pour garantir une pression de contact adéquate entre les plages de connexion.

De manière avantageuse, et lorsque les organes de positionnement disposés d'un même côté d'une des portions superposées sont reliés rigidement l'un à l'autre, ceux-ci forment une seule pièce avec le bourrelet.

Lorsque la liaison électrique est réalisée sans l'interposition d'un connecteur, la pression entre les plages de connexion pourrait être insuffisante pour garantir sa fiabilité. C'est pourquoi les plages de connexion sont alors en contact les unes avec les autres par moins de 30% de leur surface totale.

D'autres avantages et caractéristiques de l'invention ressortiront de la description qui va suivre, faite en regard du dessin annexé, dans lequel:
- la figure 1 représente, en éclaté, une première forme de réalisation du système d'interconnexion selon l'invention;
- la figure 2 représente, en éclaté, une deuxième forme de réalisation du système selon l'invention;
- la figure 3 montre en a et b les organes de positionnement du système de la figure 2, respectivement avant et après assemblage;
- la figure 4 représente, en éclaté, une troisième forme de réalisation du système; et
- la figure 5 montre, vues de dessus, deux variantes d'exécution des plages de connexion.

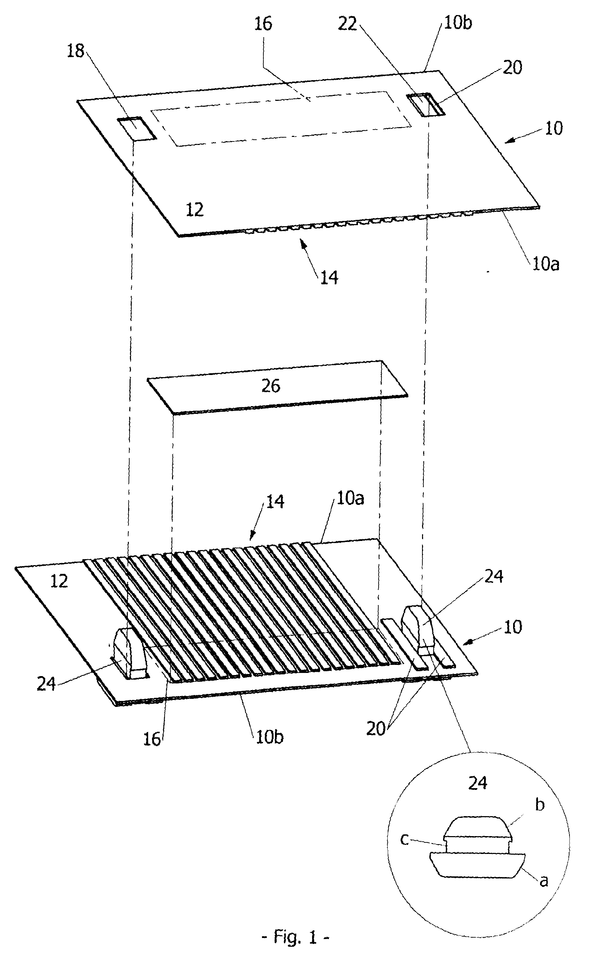

Le système d'interconnexion électrique représenté à la figure 1 comporte deux circuits imprimés identiques 10 comprenant un substrat 12 sur une face duquel est formé un réseau de pistes conductrices rectilignes parallèles 14. Ces circuits sont placés l'un sur l'autre, de façon que les deux réseaux 14 soient en regard l'un de l'autre. Chaque circuit 10 est relié, par son extrémité 10a, à des composants électroniques non représentés, alors qu'à son extrémité opposée 10b, les extrémités des pistes 14 constituent un ensemble de plages de connexion 16 qui doivent être réunies à celles de l'autre circuit de manière à réaliser l'interconnexion des deux réseaux.

A cet effet, l'extrémité 10b de chaque circuit comporte, de chaque côté de ses plages de connexion 16, une découpe rectangulaire 18 parallèle aux pistes 14. Par ailleurs, sur l'un des côtés seulement de chaque circuit, les bords de la découpe 18 possèdent deux bandes de guidage 20. Celles-ci présentent la double particularité de déborder légèrement sur la découpe 18 de manière à délimiter une fenêtre 22 et d'être constituées de pistes conductrices formées en même temps et de la même manière que le réseau de pistes 14. De ce fait, chaque fenêtre 22 est positionnée avec une grande précision par rapport aux pistes. Les deux circuits étant identiques, il suffit que leurs fenêtres respectives 22 soient mises précisément en regard l'une de l'autre pour que les plages de connexion 16 de leurs deux réseaux soient, elles aussi, parfaitement superposées.

Pour assurer ce positionnement précis, il est prévu deux boutons identiques à section rectangulaire 24 qui s'engagent respectivement dans les deux fenêtres 22 et les deux découpes 18 non dotées de bandes de guidage. Chaque bouton 24 comporte une partie inférieure a, disposée en dessous du circuit inférieur, une partie supérieure b disposée au-dessus du circuit supérieur et une partie médiane c logée dans les fenêtres 22 ou les découpes 18.

La partie médiane 24c est dimensionnée de manière à s'ajuster dans les fenêtres 22, tandis que les parties inférieure 24a et supérieure 24b sont dimensionnées de manière à ce que leurs pourtours viennent en appui contre les faces des deux circuits.

Enfin, un connecteur 26 est interposé entre les deux plages de connexion 16. Il se présente avantageusement sous la forme d'un film comportant une matrice en matériau thermo-soudable dans laquelle sont dispersées des particules conductrices comme, par exemple, le film vendu par la maison 3M (USA) sous la référence 5303R.

Pour assembler le système d'interconnexion qui vient d'être décrit, on commence par introduire les deux boutons 24 respectivement dans la découpe 18 et la fenêtre 22 du circuit inférieur 10, le passage de la partie 24b s'effectuant grâce à une légère déformation élastique du pourtour de la découpe 18. Les boutons se trouvent ainsi accrochés au circuit.

Le connecteur 26 est alors disposé sur les plages de connexion 16 du circuit inférieur 10, puis le circuit supérieur est appliqué sur l'ensemble en faisant entrer les extrémités des deux boutons 24 dans sa découpe 18 et sa fenêtre 22. Les plages de connexion 16 des deux circuits se trouvent ainsi parfaitement superposées.

Il ne reste plus, alors, qu'à mettre l'empilement sous pression et le chauffer de manière à faire adhérer le connecteur 26 aux deux circuits et réaliser ainsi leur assemblage dans des conditions optimales de précision.

Il est à noter que les boutons 24 servent essentiellement à assurer le positionnement précis des deux circuits durant l'assemblage. Dès que le connecteur 26 les a collés ensemble, les boutons n'ont plus alors pour but que de renforcer la résistance mécanique du système s'il est soumis à des contraintes.

On remarquera aussi que le connecteur 26 a la double fonction d'assurer l'interconnexion des circuits et de les maintenir assemblés. Bien entendu, le démontage du système peut être effectué en chauffant l'empilement pour permettre que le connecteur se décolle des deux circuits.

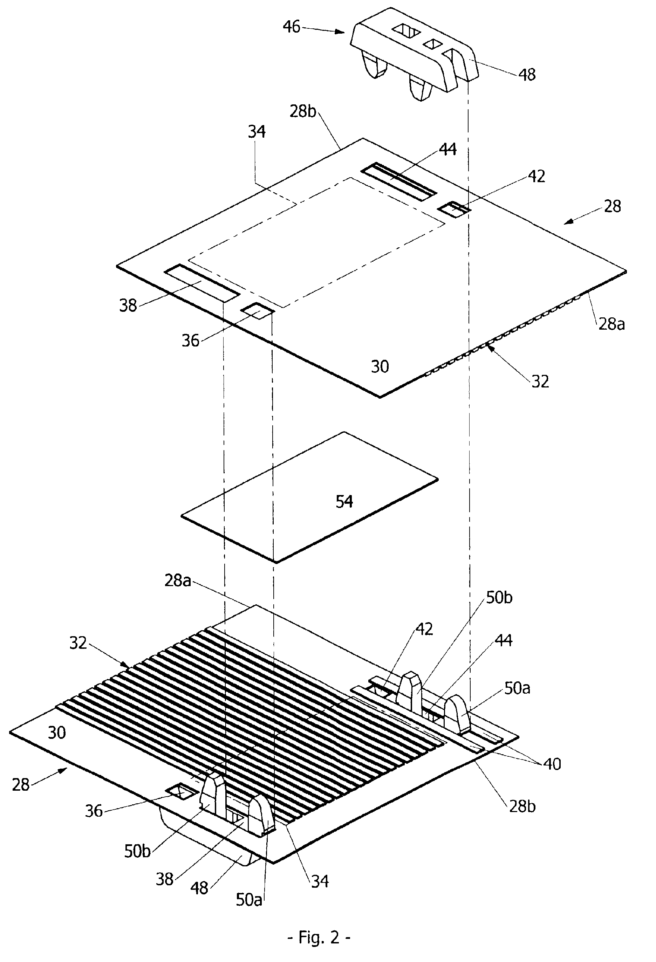

On se référera maintenant à la figure 2 qui représente un deuxième mode de réalisation d'un système selon l'invention. On peut y voir deux circuits imprimés identiques 28 comportant un substrat 30 sur lequel est formé un réseau de pistes conductrices 32. Ces circuits sont placés l'un sur l'autre, de façon que les deux réseaux 32 soient en regard l'un de l'autre. Chaque circuit 28 est relié, par son extrémité 28a, à des composants électroniques non représentés, alors qu'à son extrémité opposée 28b, les extrémités des pistes 32 constituent un ensemble de plages de connexion 34 qui doivent être réunies à celles de l'autre circuit de manière à réaliser l'interconnexion des deux réseaux.

A cet effet, l'extrémité 28b comporte, de chaque côté de ses plages de connexion 34, deux découpes rectangulaires 36 et 38 parallèles aux pistes 32, la deuxième étant plus allongée que la première. Par ailleurs, sur l'un des côtés seulement de chaque circuit, les bords de ces découpes possèdent deux bandes de guidage 40 qui débordent légèrement vers leur intérieur de manière à délimiter deux fenêtres 42 et 44. Ces bandes ont la particularité d'être constituées de pistes conductrices formées en même temps et de la même manière que le réseau de pistes 32. Ainsi, chacune des fenêtres 42 et 44 est positionnée avec une grande précision par rapport aux pistes. Les deux circuits étant identiques, il suffit que leurs paires de fenêtres respectives soient mises précisément en regard les unes des autres pour que les plages de connexion 34 soient, elles aussi, parfaitement superposées.

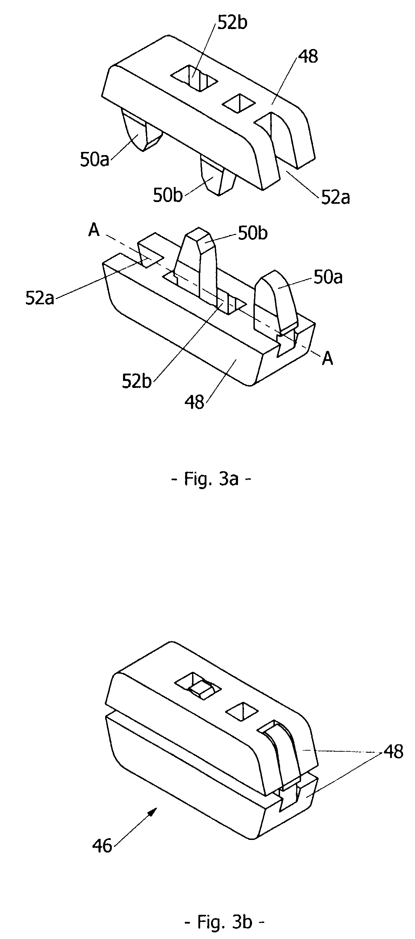

Pour assurer ce positionnement précis, le système de la figure 2 utilise deux organes de positionnement identiques 46 qui s'engagent respectivement dans les fenêtres 42-44 et les découpes 36-38 non dotées de bandes de guidage. Ces organes, représentés à la figure 3a en position ouverte et à la figure 3b en position fermée, sont constitués chacun de deux attaches identiques 48, à section rectangulaire et de forme généralement trapézoïdale, de la base desquelles émergent deux crochets identiques 50a et 50b montés en opposition et alignés selon un axe A-A parallèle aux grands côtés du rectangle. Le premier 50a est situé à une extrémité de la base, tandis que le deuxième 50b est décalé par rapport à son autre extrémité d'une distance correspondant sensiblement au tiers de sa longueur. La base de chaque attache 48 est percée de deux dégagements traversants 52a et 52b, également alignés dans l'axe A-A. Le premier 52a est formé à l'extrémité opposée à celle qui comporte le crochet 50a, tandis que le deuxième 52b est adjacent au crochet 50b du côté faisant face au crochet 50a.

Les crochets 50a-b et les dégagements 52a-b sont dimensionnés, conformés et positionnés de manière à ce que, comme le montre la figure 3b, les deux attaches 48 étant disposées tête-bêche, d'une part, chaque crochet 50a de l'une pénètre dans le dégagement 52a de l'autre et, d'autre part, chaque crochet 50b de l'une pénètre dans le dégagement 52b de l'autre.

Par ailleurs, la largeur des fenêtres 42 et 44 est telle que les crochets 50a-b y sont ajustés. En revanche, ceux-ci traversent librement les découpes 36 et 38 qui ne possèdent pas de bandes de guidage. En outre, la longueur des grandes découpes 38 et des grandes fenêtres 44 est ajustée pour que leurs extrémités coopèrent avec les crochets 50a-b afin de permettre l'accrochage des attaches 48 aux circuits imprimés 28.

Enfin, un connecteur 54, disposé entre les deux plages de connexion 34, a pour double fonction d'assurer la liaison électrique entre celles-ci et de coller ensemble les deux circuits. Ce connecteur est du même type que celui utilisé dans le mode de réalisation de la figure 1.

Pour assembler le système de la figure 3, on commence par introduire deux attaches 48 respectivement dans la grande découpe 38 et la grande fenêtre 44 des deux circuits 28. Comme déjà mentionné, les attaches 48 restent alors accrochées aux circuits, contre lesquels leurs bases se trouvent appliquées.

Le connecteur 54 est ensuite déposé sur les plages de connexion 34 du circuit inférieur, puis le circuit supérieur est appliqué tête-bêche sur l'ensemble. L'accouplement des paires d'attaches 48 est alors réalisé de manière à ce que:
- les crochets 50a des attaches inférieures passent, d'un côté, au travers de la grande découpe 38 du circuit inférieur et de la petite découpe 36 du circuit supérieur et, de l'autre côté, au travers de la grande fenêtre 44 du circuit inférieur et de la petite fenêtre 42 du circuit supérieur;
- les crochets 50b des attaches inférieures passent, d'un côté, au travers de la grande découpe 38 du circuit inférieur et du circuit supérieur et, de l'autre côté, au travers de la grande fenêtre 44 du circuit inférieur et du circuit supérieur;
- les crochets 50a des attaches supérieures passent, d'un côté, au travers de la grande découpe 38 du circuit supérieur et de la petite découpe 36 du circuit inférieur et, de l'autre côté, au travers de la grande fenêtre 44 du circuit supérieur et de la petite fenêtre 42 du circuit inférieur; et
- les crochets 50b des attaches supérieures passent d'un côté, au travers de la grande découpe 38 du circuit inférieur et du circuit supérieur et, de l'autre côté, au travers de la grande fenêtre 44 du circuit supérieur et du circuit inférieur.

Les plages de connexion 34 des deux circuits se trouvant ainsi parfaitement superposées, il ne reste plus qu'à mettre l'empilement sous pression et le chauffer de manière à coller le connecteur 54 aux deux circuits et réaliser ainsi leur assemblage dans des conditions optimales de précision.

Selon une variante de réalisation qui n'a pas été représentée, les crochets 50 des attaches 48 peuvent être fixés à cran dans les dégagements 52. Dans ce cas, les attaches font office non seulement de moyens de positionnement mais aussi de moyens d'assemblage des deux circuits 28, ayant ainsi une fonction complémentaire de la fonction de collage assurée par le connecteur 54.

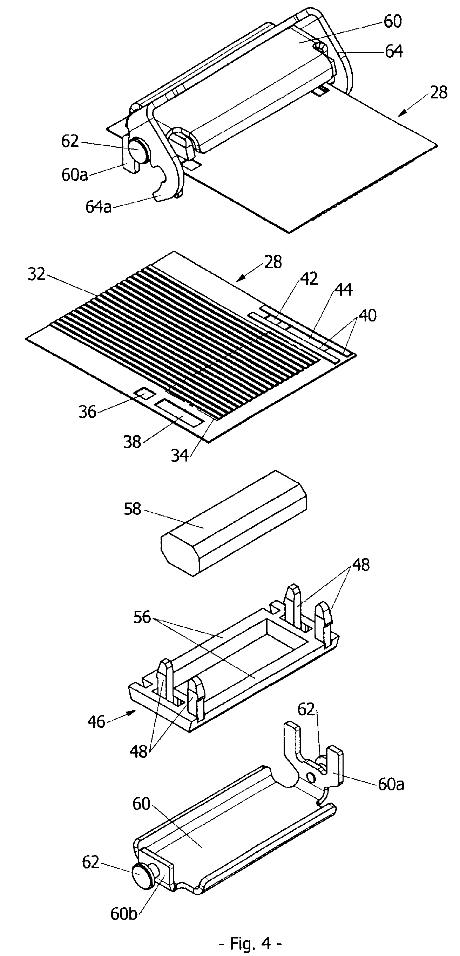

Dans certaines applications, il est nécessaire de disposer d'un système qui permet d'assembler les circuits de manière sûre et rigide et de les séparer facilement. La solution décrite en référence à la figure 4 permet d'atteindre ce but.

Sur cette figure, les fenêtres 42 et 44 et les attaches 48 sont identiques à celles représentées sur les figures 2 et 3. Les mêmes numéros de référence sont utilisés pour désigner les éléments communs aux deux réalisations.

Les éléments de la moitié inférieure du système sont montrés en éclaté, alors que les éléments de sa moitié supérieure sont montrés assemblés.

Une différence importante par rapport à la réalisation des figures 2 et 3 réside dans le fait que les deux attaches inférieures et les deux attaches supérieures 48 sont respectivement réunies par deux bras rigides 56 entre lesquels prend place un bourrelet élastique 58. Le tout est fixé, avantageusement par collage ou par soudage aux ultra-sons, sur une barrette 60 en tôle pliée dont les deux extrémités 60a et 60b, relevées à 90°, ont respectivement la forme d'une fourche à deux branches et d'un doigt de largeur légèrement inférieure à l'écart entre les deux branches.

Lors de l'assemblage, les barrettes inférieure et supérieure 60 sont accouplées tête-bêche de manière à ce que le doigt 60b de l'une prenne place dans la fourche 60a de l'autre.

Pour assurer un accouplement solide des circuits, les extrémités 60a-b des deux barrettes comportent chacune un clou rivé 62. Une bride 64 est montée pivotante sur les clous 62 de la barrette supérieure. Ses extrémités 64a viennent s'engager sur les clous 62 de la barrette inférieure de manière à verrouiller le système tout en comprimant les circuits imprimés l'un sur l'autre, par déformation élastique des bourrelets 58, pour engendrer une pression de contact assurant la liaison électrique entre les plages de connexion.

Dans un mode de réalisation particulièrement simple, les attaches 48, les bras rigides 56 et le bourrelet 58 peuvent être réalisés en une seule pièce, par injection.

La pratique a montré que la qualité du contact électrique entre les plages de connexion 34 dépend considérablement de la pression exercée sur elles.

Lorsqu'un connecteur tel que 26 (figure 1) ou 54 (figure 2) est utilisé, la densité des particules conductrices du film définit cette pression. Lorsqu'il n'y a pas de connecteur (figure 4), et que le contact est donc réalisé directement entre les plages 34, si ces dernières sont rectilignes, (figure 4), la surface de contact est élevée et, en conséquence, la pression faible.

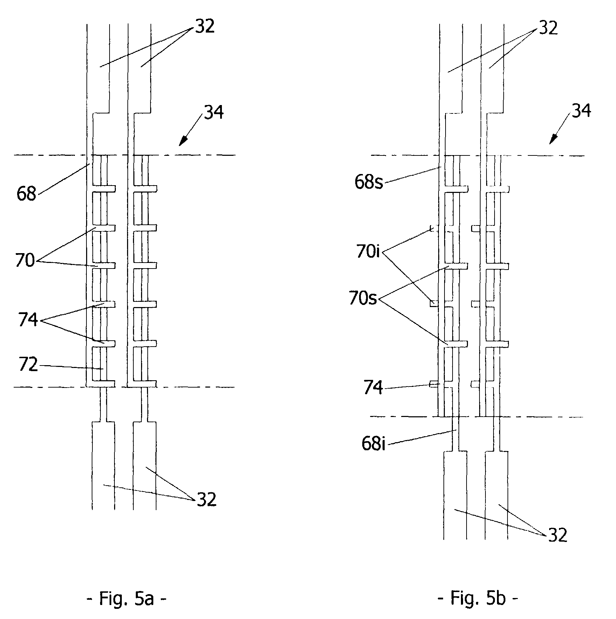

Pour pallier cet inconvénient, et comme illustré par les figures 5a et 5b, les plages de connexion 34 des pistes conductrices 32 présentent une structure particulière.

Sur la figure 5a, les plages 34 du circuit supérieur sont chacune formées d'une bande rectiligne 68 et de pattes 70 disposées orthogonalement par rapport à la bande 68. Les plages 34 du circuit inférieur sont des bandes rectilignes 72, décalées par rapport aux bandes 68 de manière à croiser les pattes 70. De petites surfaces de contact 74 sont ainsi constituées aux intersections.

Dans le mode de réalisation de la figure 5b, les plages 34 des deux circuits comportent également des bandes rectilignes 68 et des pattes 70, mais elles sont respectivement décalées latéralement et longitudinalement, de manière que les pattes 70i du circuit inférieur croisent la bande 68s du circuit supérieur et que, de même, les pattes 70s du circuit supérieur croisent les bandes 68i du circuit inférieur. Des surfaces de contact 74 sont constituées aux intersections. Dans les deux cas, les essais ont montré que les surfaces de contact 74 doivent représenter moins de 30%, typiquement 10%, de la surface totale des plages de connexion.

Il est bien évident que d'autres structures peuvent être utilisées pour assurer une pression de contact adéquate.

Le système décrit pourrait encore faire l'objet de nombreuses variantes sans pour autant sortir du cadre de l'invention. Dans une variante particulièrement intéressante, les bandes de guidage sont renforcées, par exemple au moyen d'une couche de nickel, déposée après la formation du réseau de pistes conductrices sur le circuit imprimé.

## Revendications

1. Système d'interconnexion électrique comportant:
- deux circuits imprimés (10, 28) ayant des portions superposées et comprenant chacun un substrat (12, 30) et un réseau de pistes conductrices (14, 32) qui sont formées sur le substrat et sont dotées de plages de connexion (16, 34) dans leurs portions superposées ,
- des moyens de positionnement desdites plages en regard les unes des autres, et
- des moyens d'assemblage (26, 54, 60) des deux circuits imprimés entre eux,
caractérisé en ce que lesdits moyens de positionnement comportent, d'une part, au moins deux fenêtres (22, 42, 44) identiques respectivement pratiquées dans chacune desdites portions et dont le pourtour est au moins partiellement défini par des bandes de guidage (20, 40) constituées de pistes conductrices appartenant audit réseau (14, 32) et, disposées de manière identique par rapport aux plages de connexion (16, 34) et, d'autre part, un organe de positionnement (24, 46) introduit dans les deux fenêtres (22, 42, 44) à l'intérieur desquelles il est ajusté.

2. Système d'interconnexion électrique selon la revendication 1, caractérisé en ce que chacune desdites portions superposées comporte deux fenêtres (42, 44) pratiquées respectivement de chaque côté de son réseau de pistes conductrices.

3. Système d'interconnexion électrique selon l'une des revendications 1 et 2, caractérisé en ce que ledit organe de positionnement est formé d'un bouton (24) comportant une portion médiane rétrécie (c) et deux extrémités (a, b), ladite portion médiane étant ajustée dans lesdites fenêtres (22) et les bords desdites extrémités (a, b) prenant respectivement appui sur les deux circuits (10).

4. Système d'interconnexion électrique selon l'une des revendications 1 et 2, caractérisé en ce que ledit organe de positionnement est formé de deux éléments (46) accouplés entre eux au travers desdites fenêtres et comportant une portion rétrécie (50) et une base (48), les portions rétrécies étant ajustées dans les fenêtres 42, 44) et les bords desdites bases prenant respectivement appui sur les deux circuits (28).

5. Système d'interconnexion électrique selon la revendication 4, caractérisé en ce que lesdits éléments (46) sont identiques et comportent au moins une partie femelle (52a-b) et au moins une partie mâle (50a-b) et en ce qu'ils sont accouplés tête-bêche de manière à ce que la partie mâle de l'un prenne place dans la partie femelle de l'autre.

6. Système d'interconnexion électrique selon la revendication 5, caractérisé en ce lesdits éléments comportent chacun deux parties femelles (52a, 52b) et deux parties mâles (50a, 50b).

7. Système d'interconnexion électrique selon la revendication 2, caractérisé en ce que les organes de positionnement (46, 56) disposés d'un même côté d'une desdites portions superposées sont reliés rigidement l'un (46) à l'autre (56).

8. Système d'interconnexion électrique selon la revendication 1, caractérisé en ce que ledit organe de positionnement (24, 46) est maintenu par accrochage à au moins l'un des deux circuits (10, 28).

9. Système d'interconnexion électrique selon l'une des revendications 1 à 8, caractérisé en ce que lesdits moyens d'assemblage (26, 54) comportent une couche de matériau thermo-soudable conducteur assurant le collage des deux substrats ainsi que la liaison électrique entre lesdites plages de connexion.

10. Système d'interconnexion électrique selon l'une des revendications 1 à 8, caractérisé en ce que lesdits moyens d'assemblage comportent deux barrettes rigides (60) disposées de part et d'autre des deux circuits (28) au niveau de l'organe de positionnement et des moyens (62, 64) pour accoupler lesdites barrettes et serrer entre elles les circuits.

11. Système d'interconnexion électrique selon la revendication 10, caractérisé en ce qu'un bourrelet élastique (58) est interposé entre chaque barrette (60) et le circuit (28).

12. Système d'interconnexion selon les revendications 7 et 11, caractérisé en ce que les organes de positionnement disposés d'un même côté (46, 56) et ledit bourrelet (58) forment ensemble une seule pièce.

13. Système selon l'une des revendications 10 à 12, caractérisé en ce que lesdites plages de connexion (34) sont en contact (74) les unes avec les autres par moins de 30% de leur surface totale.
